(19) Europäisches Patentamt
European Patent Office
Office européen des brevets

(11) EP 1 131 890 B1

(12) **FASCICULE DE BREVET EUROPEEN**

(45) Date de publication et mention de la délivrance du brevet:
**03.11.2004 Bulletin 2004/45**

(21) Numéro de dépôt: **00964339.6**

(22) Date de dépôt: **21.09.2000**

(51) Int Cl.[7]: **H03M 1/74**

(86) Numéro de dépôt international:
**PCT/FR2000/002617**

(87) Numéro de publication internationale:
**WO 2001/022596 (29.03.2001 Gazette 2001/13)**

(54) **CONVERTISSEUR NUMERIQUE/ANALOGIQUE**

DIGITAL/ANALOGWANDLER

DIGITAL-TO-ANALOG CONVERTER

(84) Etats contractants désignés:
**AT BE CH CY DE DK ES FI FR GB GR IE IT LI LU MC NL PT SE**

(30) Priorité: **22.09.1999 FR 9911827**

(43) Date de publication de la demande:
**12.09.2001 Bulletin 2001/37**

(73) Titulaire: **ATMEL NANTES SA**
**44300 Nantes (FR)**

(72) Inventeur: **GERBER, Rémi**
**F-44300 Nantes (FR)**

(74) Mandataire: **Fréchède, Michel**
**Cabinet Plasseraud**
**84, rue d'Amsterdam**
**75440 Paris Cédex 09 (FR)**

(56) Documents cités:
- **PATENT ABSTRACTS OF JAPAN vol. 009, no. 010 (E-290), 17 janvier 1985 (1985-01-17) -& JP 59 160319 A (NIPPON GAKKI SEIZO KK), 11 septembre 1984 (1984-09-11)**
- **PATENT ABSTRACTS OF JAPAN vol. 016, no. 055 (E-1165), 12 février 1992 (1992-02-12) & JP 03 255722 A (NEC CORP), 14 novembre 1991 (1991-11-14)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Printed by Jouve, 75001 PARIS (FR)

EP 1 131 890 B1

## Description

L'invention concerne un convertisseur numérique/ analogique à exécution immédiate.

Les convertisseurs numériques/analogiques actuels présentent un temps de conversion de l'ordre de plusieurs centaines de nanosecondes, en raison de l'existence de circuits analogiques, destinés à restituer la tension analogique convertie par intégration.

Afin de réduire ce temps de conversion, des solutions consistant à diminuer les capacités d'intégration ont été proposées. Ces solutions présentent toutefois un effet limité, dans la mesure où une telle réduction se heurte au principe même du mode opératoire de ces systèmes.

La présente invention a pour objet de remédier aux inconvénients et limitations des convertisseurs numériques/analogiques de l'art antérieur par la mise en oeuvre d'un convertisseur numérique/analogique à exécution immédiate, dans lequel le temps de réponse n'excède pas le temps de commutation cumulé de modules de circuits amplificateurs linéaires. JP59160319 montre un convertisseur numérique/ analogique à exécution immédiate avec une echelle de résistances.

Un autre objet de la présente invention est également la mise en oeuvre d'un convertisseur numérique/analogique autoprogrammable, dans lequel le processus d'autoprogrammation est directement conduit par la valeur numérique à convertir en valeur analogique.

Le convertisseur numérique/analogique à exécution immédiate, objet de la présente invention, permet de convertir une valeur numérique codée sur N bits en une tension analogique, de valeur comprise entre une tension électrique d'alimentation Vcc et une tension de référence, la tension de masse.

Il est remarquable en ce qu'il comporte au moins des circuits générateurs programmables d'un courant électrique image proportionnel à la somme des valeurs actives de tensions électriques d'une suite de N tensions électriques constituant une progression géométrique de raison ½ et formant une image analogique du poids des bits entre le bit le plus significatif et le bit le moins significatif sur lesquels la valeur numérique à convertir est codée, les valeurs actives correspondant aux valeurs pour lesquelles l'image analogique du poids des bits de la valeur numérique à convertir correspond à un bit de valeur 1.

Il comporte également des premiers circuits correcteurs programmables recevant le courant électrique image et permettant d'engendrer une première tension analogique corrigée programmée proportionnelle à la différence entre la tension d'alimentation Vcc et la somme pondérée des valeurs actives de tensions électriques de la suite de tensions électriques, le terme de pondération de la somme pondérée étant inversement proportionnel au nombre de bits à la valeur 1 de la valeur numérique à convertir, et des deuxièmes circuits correcteurs recevant la première tension analogique corrigée programmée et permettant d'engendrer une deuxième tension analogique corrigée programmée, sensiblement égale en grandeur et en signe à la somme pondérée des valeurs actives de tensions électriques de la suite de tensions électriques.

Il comporte enfin des troisièmes circuits correcteurs recevant la deuxième tension analogique corrigée programmée et permettant d'appliquer un gain programmé, égal à l'inverse du terme de pondération, ceci permettant d'engendrer la tension analogique comprise entre la tension d'alimentation et la tension de référence, valeur égale à la somme des valeurs actives de tensions électriques de la suite de tensions électriques.

Le convertisseur numérique/analogique à exécution immédiate, objet de l'invention, trouve application à tout domaine d'électronique rapide, tel que l'électronique aéronautique et spatiale, la conversion de signaux audio- et/ou vidéonumériques par exemple.

Il sera mieux compris à la lecture de la description et à l'observation des dessins dans lesquels :

- la figure 1a représente, à titre d'exemple non limitatif, un premier exemple de réalisation du convertisseur numérique/analogique, objet de la présente invention ;
- la figure 1b représente, à titre d'exemple non limitatif, un deuxième exemple de réalisation du convertisseur numérique/analogique, objet de la présente invention.

Une description plus détaillée d'un convertisseur numérique/analogique autoprogrammable à exécution immédiate, conforme à l'objet de la présente invention, sera maintenant donnée en référence à la figure 1a dans un mode de réalisation non limitatif.

En référence à la figure précitée, on indique que le convertisseur numérique/analogique reçoit une valeur numérique à convertir, codée sur N bits, les bits de codage étant notés $b_0$, pour le bit le moins significatif, à $b_{N-1}$ pour le bit le plus significatif, le bit courant étant noté $b_j$. La tension analogique engendrée est désignée par $V_{OUT}$. La valeur de cette tension analogique est, par définition, comprise entre la tension électrique d'alimentation Vcc et une tension de référence, notée $V_{REF}$ encore désignée par tension de masse.

Selon un aspect particulièrement remarquable du convertisseur numérique/analogique objet de la présente invention, celui-ci comprend des circuits 1 générateurs programmables d'un courant électrique image, noté $I_i$, propor-

tionnel à la somme des valeurs actives de tensions électriques d'une suite de N tensions électriques constituant une progression géométrique de raison ½. La suite des N tensions électriques forme une image analogique du poids des bits de codage de la valeur numérique à convertir entre le bit le plus significatif $b_{N-1}$ et le bit le moins significatif $b_0$ sur lesquels la valeur numérique à convertir est codée ou représentée. D'une manière générale, on indique que la suite des N tensions électriques constituant une progression géométrique de raison ½ vérifie de préférence la relation (1) :

$$V_j = Vcc/2^{N-j}$$

De la même manière, on indique que les valeurs actives correspondent aux valeurs de tensions électriques de la suite de tensions électriques en progression géométrique de raison ½ pour lesquelles l'image analogique du poids des bits de la valeur numérique à convertir correspond à un bit de valeur 1.

Compte tenu de la définition précédente, chaque valeur active de tension électrique, notée $Vx_j$, vérifie la relation (2) :

$$Vx_j = b_j.Vcc/2^{N-j}.$$

On comprend, en particulier, que les valeurs actives de tensions électriques, pour la valeur des bits $b_j$ égale à la valeur 1, sont égales à la valeur correspondante de l'image analogique du poids des bits représentée par la tension électrique correspondante de la suite des N tensions électriques constituant la progression géométrique, alors que, pour la valeur zéro de ces bits, la valeur active correspondante est bien entendu égale à zéro.

En outre, ainsi que représenté en figure la, le convertisseur numérique/analogique, objet de l'invention, comprend des premiers circuits 2 correcteurs programmables recevant le courant électrique image $I_i$ proportionnel à la somme des valeurs actives de tensions électriques précitées, ces premiers circuits 2 permettant d'engendrer une première tension analogique corrigée programmée, notée $V_A$ proportionnelle à la différence entre la tension d'alimentation Vcc et la somme pondérée des valeurs actives de tensions électriques de la suite de tensions électriques représentée par le courant électrique image $I_i$ précité. Le terme de pondération de la somme pondérée est inversement proportionnel au nombre de bits $\alpha$ à la valeur 1 de la valeur numérique à convertir.

Ainsi qu'on l'observera également sur la figure 1a, le convertisseur numérique/analogique, objet de l'invention, comprend en outre des deuxièmes circuits correcteurs 3 recevant la première tension analogique corrigée programmée $V_A$ et permettant d'engendrer une deuxième tension analogique corrigée programmée $V_B$ sensiblement égale en grandeur et en signe à la somme pondérée des valeurs actives de tensions électriques de la suite de tensions électriques.

Enfin, le convertisseur numérique/analogique, objet de l'invention, tel que représenté en figure 1a, comprend des troisièmes circuits correcteurs 4 recevant la deuxième tension analogique corrigée programmée $V_B$ et permettant d'appliquer un gain programmé égal à l'inverse du terme de pondération, ces troisièmes circuits correcteurs 4 permettant ainsi d'engendrer la tension analogique $V_{OUT}$ de valeur comprise entre la tension d'alimentation Vcc et la tension de référence $V_{REF}$ et dont la valeur est égale à la somme des valeurs actives de tensions électriques de la suite de tensions électriques selon la relation (2).

Une description plus détaillée des différents modules constitutifs du convertisseur numérique/ analogique, objet de la présente invention, sera maintenant donnée également en référence à la figure 1a.

Pour engendrer le courant électrique image $I_i$ proportionnel à la somme des valeurs actives de tensions électriques $Vx_j$, un mode de réalisation préférentiel peut consister à construire les circuits 1 générateurs programmables de manière à ce que celui-ci comporte, en référence à la figure 1a, au moins une pluralité, notée 10, de N ponts diviseurs de tension électrique connectés en cascade entre la tension d'alimentation et la tension de référence. Sur la figure 1a, on a représenté la pluralité de ponts diviseurs comme constitués par des ponts $R_0/2R_0$, $R_0$ désignant une valeur de résistance déterminée. En référence à la figure 1a, on indique que la borne d'entrée du premier pont diviseur est connectée à la tension d'alimentation Vcc, la résistance $2R_0$ étant connectée à la tension de référence, et le point milieu de ce pont diviseur constituant le point milieu $M_{N-3}$ délivrant pour N=4, nombre de bits cité à titre d'exemple non limitatif, une première valeur de la suite de N tensions électriques en progression géométrique de raison ½ et dont la valeur est égale à $Vcc/2^1$ pour j=3.

De la même manière, le deuxième pont diviseur est constitué par un pont $R_0/2R_0$, l'entrée du pont diviseur par la résistance $R_0$ étant connectée au point milieu du pont précédent de rang j=3 et le point milieu du pont considéré pour j=2 délivrant une tension électrique $Vcc/2^2$.

Les ponts successifs sont construits de la même manière et délivrent ainsi les valeurs de tension en progression géométrique de raison ½ pour j=1, soit Vcc/8, et, pour j=0, la valeur de tension Vcc/16. En effet, chaque pont diviseur successif est connecté au point milieu du pont diviseur de rang voisin, le point milieu de chaque pont diviseur de rang j donné délivrant ainsi une tension électrique de valeur $Vcc/2^{N-j}$ constitutive de la suite de valeurs de tensions

électriques.

En outre, les circuits 1 générateurs programmables comportent, ainsi que représenté en figure la, une pluralité, notée 11, de N circuits série, N étant ici égal à 4, chacun formé par une résistance de valeur déterminée, laquelle peut bien entendu être distincte de la valeur $R_0$ précédemment mentionnée dans la description, et par un interrupteur noté $SW_0$, $SW_j$, ... , $SW_{N-1}$, ces interrupteurs étant bien entendu programmables en valeurs ouverte, respectivement fermée en fonction de la valeur d'un des bits $b_0$ à $b_{N-1}$ constitutifs de la valeur numérique à convertir.

Ainsi, à titre d'exemple non limitatif, sur la figure 1a, le bit le moins significatif LSB, c'est-à-dire le bit $b_0$, est représenté par l'interrupteur $SW_0$ et le bit le plus significatif MSB, c'est-à-dire le bit $b_3$, est représenté par l'interrupteur $SW_3$. La borne d'entrée de chaque circuit série est connectée au point milieu d'un des ponts diviseurs successifs. Dans une version préférentielle non limitative, cette connexion, ainsi que représenté en figure 1a, est réalisée par l'intermédiaire d'un amplificateur séparateur, noté $A_0$, ... , $A_j$ à $A_3$, cet amplificateur séparateur ayant pour objet de séparer chaque circuit série des ponts diviseurs successifs sur lesquels ils sont branchés afin d'éviter toute interaction électrique néfaste, les amplificateurs séparateurs $A_j$ pouvant présenter une impédance de sortie très faible et une impédance d'entrée très élevée, de manière à réaliser cette fonction de séparation. Le mode de réalisation de ces amplificateurs séparateurs ne sera pas décrit en détail car il correspond à un mode de réalisation connu de l'homme de l'art.

Ainsi, chaque circuit série reçoit une tension électrique de valeur $Vcc/2^{N-j}$ et délivre, en fonction de la position programmée, fermée ou ouverte, de l'interrupteur correspondant $SW_j$, par le bit correspondant $b_j$ à la valeur 1 ou 0 de la valeur numérique à convertir, un courant électrique image élémentaire, noté $I_{ij}$, lequel est proportionnel à la valeur de tension $Vcc/2^{N-j}$. Ainsi, la valeur de chaque courant électrique image élémentaire $I_{ij}$ correspond à une valeur active des tensions électriques de la suite des tensions électriques pour un bit de valeur 1 et un courant électrique image élémentaire de valeur nulle correspond à une valeur non active des tensions électriques de la suite de tensions électriques pour un bit de valeur zéro.

Dans ces conditions, chaque courant électrique image élémentaire $I_{ij}$ est proportionnel à la valeur active précitée, laquelle vérifie la relation (2) précédemment mentionnée dans la description.

Ainsi que représenté en outre sur la figure 1a, la borne de sortie de chacun des signaux constituant la pluralité de circuits série est connectée en parallèle pour délivrer le courant électrique image $I_i$ précédemment mentionné, somme des courants images élémentaires $I_{ij}$. Ainsi, le courant électrique image $I_i$ est proportionnel à la somme des valeurs actives des tensions électriques précitées.

Dans un mode de réalisation non limitatif préférentiel, pour des amplificateurs séparateurs $A_j$ de gain 1, chaque courant électrique image élémentaire et en conséquence le courant électrique image est proportionnel à l'inverse de la résistance R constitutive de chaque circuit série.

En ce qui concerne les premiers circuits 2 correcteurs programmables, et compte tenu de la valeur précédemment indiquée du courant électrique image $I_i$, ces derniers peuvent comporter, ainsi que représenté en figure la, un amplificateur opérationnel, noté 20, dont la borne d'entrée négative est montée en borne de pseudo-masse virtuelle et reçoit le courant électrique image $I_i$ délivré par les circuits 1 générateurs programmables. La borne de sortie de l'amplificateur opérationnel 20 est connectée en contre-réaction à la borne négative précitée par l'intermédiaire d'une pluralité de N circuits série formés chacun par une résistance R de même valeur que la résistance des circuits série constitutive des circuits 1 générateurs programmables, et par un interrupteur programmable assurant une fonction analogue à celle des interrupteurs $SW_0$, $SW_j$ à $SW_{N-j} = SW_3$ précédemment mentionnés dans la description.

En référence à la figure la, on indique que l'ensemble des N circuits série est connecté en parallèle pour assurer la boucle de contre-réaction précédemment mentionnée.

La borne d'entrée positive de l'amplificateur opérationnel 20 est elle-même connectée à une tension dite de décalage, prise de préférence égale à la moitié de la tension d'alimentation Vcc.

Dans ces conditions, la sortie de l'amplificateur opérationnel 20 délivre, pour une programmation de chacun des interrupteurs programmables en position fermée ou ouverte, en fonction de la valeur des bits $b_0$ à $b_{N-1}$ de la valeur numérique à convertir, la première tension analogique corrigée programmée $V_A$. De manière non limitative, et en fonction de la structure et de la programmation des pluralités de circuits série précités, on indique que la somme pondérée des valeurs actives de tensions électriques est définie par un terme de pondération inversement proportionnel au nombre de bits à la valeur 1 de la valeur numérique à convertir, ainsi qu'il sera explicité de manière plus détaillée dans la description.

En ce qui concerne les deuxièmes circuits correcteurs 3, compte tenu de la valeur de la première tension analogique corrigée programmée $V_A$, ceux-ci, en référence à la figure 1a, peuvent comporter avantageusement un amplificateur opérationnel 30 dont la borne négative est montée en borne de pseudo-masse virtuelle et reçoit la première tension analogique corrigée programmée $V_A$ par l'intermédiaire d'une résistance de valeur déterminée égale à la valeur R précédemment citée. La sortie de l'amplificateur opérationnel 30 est connectée en contre-réaction par une résistance de même valeur à la borne négative de ce même amplificateur opérationnel 30. En outre, la borne positive de ce dernier est connectée à une tension de décalage égale à la moitié de la tension d'alimentation Vcc.

Dans ces conditions, la sortie de l'amplificateur opérationnel 30 délivre, à partir de la première tension analogique corrigée programmée $V_A$, la deuxième tension analogique corrigée programmée $V_B$ sensiblement égale en grandeur et en signe à la somme pondérée des valeurs actives de la suite de tensions électriques.

La deuxième tension analogique corrigée programmée $V_B$ vérifie la relation :

$$V_B = \frac{1}{K(\alpha)} \sum_{j=0}^{N-1} b_j . Vx_j$$

Dans cette relation, on indique que K(α), coefficient de pondération, désigne une fonction proportionnelle à α, α désignant le nombre de bits égal à la valeur 1 de la valeur numérique à convertir.

Enfin, en ce qui concerne les troisièmes circuits correcteurs 4, ceux-ci, en référence à la figure 1a, peuvent comprendre, compte tenu de la valeur de la deuxième tension analogique corrigée programmée $V_B$, un amplificateur opérationnel 40 correcteur de gain dont la borne négative est connectée à la tension de référence $V_{REF}$ par l'intermédiaire d'une pluralité de N circuits série formés chacun par une résistance de même valeur, la valeur R, et par un interrupteur programmable assurant la même fonction que les interrupteurs programmables $SW_0$, $SW_j$ à $SW_3$ précédemment mentionnés dans la description. L'ensemble de ces N circuits série est connecté en parallèle, la borne de sortie de l'amplificateur opérationnel étant connectée en contre-réaction à la borne négative de l'amplificateur opérationnel 40 par l'intermédiaire d'une résistance de même valeur R. La borne positive de l'amplificateur opérationnel 40, connectée à la sortie des deuxièmes circuits correcteurs 3, reçoit la deuxième tension analogique corrigée programmée $V_B$. Dans ces conditions, la sortie de l'amplificateur opérationnel 40 délivre par application d'un gain inverse du terme de pondération, c'est-à-dire un gain de la forme K(α), à la deuxième tension analogique corrigée programmée, la tension analogique de sortie notée $V_{OUT}$, dont la valeur est ainsi égale à la somme des valeurs actives de tensions électriques de la suite de tensions électriques.

Dans ces conditions, la tension analogique vérifie la relation :

$$V_{OUT} = \sum_{j=0}^{N-1} b_j . Vx_j$$

Un premier mode de réalisation particulièrement avantageux non limitatif, permettant d'obtenir une valeur particulière du coefficient de pondération- K(α) sera maintenant donnée en liaison avec la figure 1a.

Sur la figure précitée, on constate que le dernier pont diviseur permettant d'engendrer la dernière valeur de tension appartenant à la suite de tensions en progression géométrique de raison ½ est en fait suivi d'un autre pont diviseur, valeur $R_0/R_0$ constituant en fait la terminaison de la succession des ponts diviseurs.

Dans ces conditions, ce pont diviseur de terminaison permet de délivrer, à partir de la dernière valeur de tension précitée, une autre valeur de tension dans le rapport ½ vis-à-vis de la précédente et qui constitue ainsi une valeur proportionnelle à la moitié de la valeur du poids du bit le moins significatif LSB. Dans l'exemple de réalisation donné en figure 1a, on rappelle que pour une valeur de tension image de la valeur du bit le moins significatif LSB = Vcc/16, la valeur de tension délivrée par le pont $R_0/R_0$ devient Vcc/32.

Ainsi, pour une valeur numérique à convertir codée sur N bits, et en référence à la figure 1a, le courant image $I_i$ comporte avantageusement une valeur de décalage, notée $I_{id}$, proportionnelle à la moitié de la valeur du poids du bit le moins significatif. Cette valeur est introduite comme pseudo-valeur active permanente afin de décaler la valeur zéro de la tension analogique obtenue d'une valeur très faible qui peut être rendue aussi faible que la valeur de la tension d'alimentation Vcc divisée par la puissance de deux du nombre de bits + 1 sur lequel la valeur numérique à convertir est codée.

Dans ce but, chaque pluralité de circuits série, des circuits 1 générateurs programmables et des circuits 2 correcteurs, comporte en outre une résistance, laquelle peut être permanente, de même valeur R, connectée directement en parallèle sur l'ensemble des circuits série correspondants. Bien entendu, dans le cas des circuits série de la pluralité de circuits série 11 des circuits générateurs programmables 1, la résistance telle que la résistance permanente R représentée en figure 1a, est reliée par l'intermédiaire d'un amplificateur séparateur A au point milieu du pont de terminaison $R_0/R_0$ précité.

Dans ces conditions et compte tenu de l'existence de cette résistance permanente, le terme de pondération

$K(\alpha)$ est alors inversement proportionnel au nombre de bits à la valeur 1 de la valeur numérique à convertir augmentée de 1. Il en est de même pour le terme de gain appliqué par les circuits de correction 3 avec $K(\alpha) = \alpha+1$.

Un justificatif théorique du mode de réalisation précité sera maintenant donné également en liaison avec la figure 1a.

En appliquant la loi des noeuds à l'entrée négative de l'amplificateur opérationnel 20, laquelle est montée en pseudo-masse virtuelle, l'équation des courants s'écrit :

Relation 3

$$\frac{\sum_{j=0}^{N-1}\left(Vx_j - \frac{Vcc}{2}\right)}{R} = \frac{\frac{Vcc}{2} - V_A}{R/(\alpha+1)}$$

Dans la relation précitée, le terme $(\alpha+1)$ est introduit du fait de l'existence de $\alpha$ bits à la valeur 1 et de la résistance permanente R dans la pluralité de circuits série 11 et 21 précédemment mentionnés dans la description.

Le développement et la simplification de la relation 3 permet d'écrire la relation 4 :

Relation 4

$$\sum_{j=0}^{N-1}\left(Vx_j - (\alpha+1)\frac{Vcc}{2}\right) = (\alpha+1)\frac{Vcc}{2} - (\alpha+1)V_A$$

La résolution de cette dernière relation donne l'expression de la première tension analogique corrigée programmée $V_A$ selon la relation 5 :

Relation 5

$$V_A = Vcc - \sum_{j=0}^{N-1}\frac{Vx_j}{(\alpha+1)}$$

Le terme de pondération est donc $K(\alpha)=1/\alpha+1$.

De la même manière, l'écriture de la loi des noeuds à l'entrée négative de l'amplificateur opérationnel 30 des deuxièmes circuits de correction 3 permet d'écrire la relation 6 :

Relation 6

$$\frac{V_A - Vcc/2}{R} = \frac{Vcc/2 - V_B}{R}$$

L'expression de la deuxième tension analogique corrigée programmée $V_B$ s'écrit alors :

Relation 7

$$V_B = Vcc - V_A = \frac{1}{\alpha+1}\sum_{j=0}^{N-1} Vx_j$$

Le terme de pondération est alors de la forme 1/K(α)=1/α+1.

Enfin, l'écriture de la loi des noeuds à l'entrée négative de l'amplificateur opérationnel 40 permet d'écrire la relation 8 :

Relation 8

$$\frac{V_B}{R/\alpha} = \frac{V_{OUT}}{R + R/\alpha}$$

ce qui, après résolution de la forme $V_{OUT}/V_B = \alpha+1$, permet d'écrire la relation 9 :

Relation 9

$$V_{OUT} = \sum_{j=0}^{N-1} Vx_j$$

Le dispositif, objet de la présente invention, tel que décrit, permet ainsi d'obtenir une tension analogique égale à la somme des valeurs actives $Vx_j$ des tensions électriques de la suite de tensions électriques précitées.

On rappelle qu'en référence à la relation (2) précédemment mentionnée dans la description, chaque tension active $Vx_j$ a la valeur nulle pour $b_j$ bits de la valeur numérique à convertir égale à zéro et la valeur $Vcc/2^{N-j}$ pour $b_j = 1$.

Le mode de réalisation tel que décrit en relation avec la figure la donne entièrement satisfaction. Toutefois, ce mode de réalisation n'est pas limitatif.

Il est en effet possible de rendre la valeur de décalage de la tension analogique par rapport à la valeur 0 aussi petite que la moitié de la valeur de la tension analogique représentative du bit le moins significatif.

En effet, l'introduction de la valeur de décalage par l'intermédiaire des résistances permanentes de valeur R représentées en figure 1a, peut être comprise comme l'introduction d'un pseudo-bit de valeur 1, non pas relativement à la valeur numérique codée à convertir mais relativement à la valeur de la tension analogique finalement obtenue.

Dans ces conditions, un mode de réalisation préférentiel tel que représenté en figure 1b, peut consister à rajouter un pseudo-bit ou bit fictif de rang j=-1 sur la figure 1b, sur toutes les pluralités de circuits série introduits, tant au niveau des pluralités de circuits série 11, 21 que 41 représentés en figure 1a.

En outre, et de manière non limitative, pour la pluralité de circuits série 11 et 21 des circuits générateurs programmables 1 et des premiers circuits correcteurs 2, une résistance permanente R peut être ajoutée ou, le cas échéant, un pseudo-bit, noté $b_{-2}$.

Dans ces conditions, et en référence à la figure 1b, on comprend que le transcodage à la valeur zéro du pseudo-bit $b_{-1}$ permet de se ramener à un fonctionnement analogue à celui de la figure 1a dans lequel toutefois la valeur de décalage de tension de la tension analogique est égale non plus à la moitié de la valeur du bit le moins

significatif, mais au quart.

Au contraire, lorsque la résistance permanente R sur la figure 1b est reliée par un interrupteur commandé par un pseudo-bit $b_{-2}$, le convertisseur numérique/analogique, objet de la présente invention, permet de prévoir un fonctionnement sur un nombre variable de bits, le nombre de bits pouvant être amené ainsi à une valeur N+2, les pseudo-bits $b_{-1}$ et $b_{-2}$ pouvant effectivement participer à la conversion d'une valeur codée sur N+1 bits. Bien entendu, le nombre de circuits série de la pluralité de circuits série, tant dans les circuits générateurs programmables 1 que les premiers circuits correcteurs 2, n'étant pas limité.

Enfin, la valeur de la tension analogique convertie est comprise entre la valeur de la tension d'alimentation Vcc et la tension de référence, tension de masse. On comprend en particulier que la valeur de la tension analogique convertie atteint la valeur Vcc lorsque tous les bits $b_0$ à $b_{N-1}$ = 1, cette valeur convergeant vers la valeur Vcc par valeur inférieure à la valeur près de la valeur de tension analogique image du bit le moins significatif. Pour cette raison, il est également possible d'alimenter la pluralité de ponts résistifs à partir d'une tension d'alimentation adaptée supérieure à la tension d'alimentation Vcc afin d'obtenir une plage de variation des valeurs converties entre la tension de référence, tension de masse, et une tension normalisée telle qu'une tension d'alimentation de circuit intégré par exemple.

## Revendications

1. Convertisseur numérique/analogique à exécution immédiate, recevant une valeur numérique à convertir, codée sur N bits, en une tension analogique de valeur comprise entre une tension électrique d'alimentation Vcc et une tension de référence, tension de masse, comportant :

   - des moyens générateurs programmables d'un courant électrique image proportionnel à la somme des valeurs actives de tensions électriques d'une suite de N tensions électriques constituant une progression géométrique de raison ½ et formant une image analogique du poids des bits entre le bit le plus significatif et le bit le moins significatif sur lesquels ladite valeur numérique à convertir est codée, lesdites valeurs actives correspondant auxdites valeurs de tensions électriques de cette suite de valeurs pour lesquelles l'image analogique du poids des bits de ladite valeur numérique à convertir correspond à un bit de valeur 1 ;

   **caractérisé en ce qu'**il comporte au moins:

   - des premiers moyens correcteurs programmables recevant ledit courant électrique image et permettant d'engendrer une première tension analogique corrigée programmée proportionnelle à la différence entre ladite tension d'alimentation Vcc et la somme pondérée desdites valeurs actives de tensions électriques de la suite de tensions électriques, le terme de pondération de ladite somme pondérée étant inversement proportionnel au nombre de bits à la valeur 1 de ladite valeur numérique à convertir ;
   - des deuxièmes moyens correcteurs recevant ladite première tension analogique corrigée programmée et permettant d'engendrer une deuxième tension analogique corrigée programmée sensiblement égale en grandeur et en signe à ladite somme pondérée desdites valeurs actives de tensions électriques de ladite suite de tensions électriques ;
   - des troisièmes moyens correcteurs recevant ladite deuxième tension analogique corrigée programmée et permettant d'appliquer un gain programmé, égal à l'inverse dudit terme de pondération, ce qui permet d'engendrer ladite tension analogique de valeur comprise entre ladite tension d'alimentation et ladite tension de référence, valeur égale à la somme desdites valeurs actives de tensions électriques de ladite suite de tensions électriques.

2. Convertisseur numérique/analogique selon la revendication 1, **caractérisé en ce que** lesdits moyens générateurs programmables d'un courant image proportionnel à la somme des valeurs actives de tensions électriques comportent au moins :

   - une pluralité de N ponts diviseurs de tension électrique $R_0/2R_0$ connectés en cascade, entre ladite tension d'alimentation et ladite tension de référence, R désignant une valeur de résistance déterminée, la borne d'entrée du premier pont diviseur étant connectée à la tension d'alimentation Vcc et la borne d'entrée de chaque pont diviseur successif étant connectée au point milieu du pont diviseur de rang voisin, le point milieu de chaque pont diviseur de rang j délivrant une tension électrique de valeur $Vcc/2^{N-j}$ constitutive de la suite de valeurs de tensions électriques ;
   - une pluralité de N circuits série, formés chacun par une résistance de valeur déterminée et un interrupteur programmable($b_0$, $b_j$ à $b_3$), la borne d'entrée de chaque circuit série étant connectée au point milieu d'un pont

diviseur et recevant une tension électrique de valeur $Vcc/2^{N-j}$, chaque circuit série délivrant, en fonction de la position programmée fermée ou ouverte de cet interrupteur, par un bit à la valeur 1 ou 0 de ladite valeur numérique à convertir, un courant électrique image élémentaire $I_{ij}$ proportionnel à ladite valeur $Vcc/2^{N-j}$, correspondant à une valeur active des tensions électriques de ladite suite de tensions électriques pour un bit de valeur 1, et un courant électrique image élémentaire de valeur nulle, correspondant à une valeur non active des tensions électriques de la suite de tensions électriques pour un bit de valeur 0, la borne de sortie de ladite pluralité de circuits série étant connectée en parallèle, pour délivrer ledit courant électrique image $I_i$, somme des courants image élémentaires $I_{ij}$, proportionnel à la somme desdites valeurs actives de tensions électriques.

**3.** Convertisseur numérique/analogique selon l'une des revendications 1 ou 2, **caractérisé en ce que** lesdits premiers moyens correcteurs programmables comprennent un amplificateur opérationnel dont la borne d'entrée négative, montée en borne de pseudo-masse virtuelle reçoit ledit courant électrique image $I_i$ délivré par lesdits moyens générateurs programmables, la borne de sortie dudit amplificateur opérationnel étant connectée en contre-réaction à ladite borne négative par l'intermédiaire d'une pluralité de N circuits série formés chacun par une résistance de même valeur et un interrupteur programmable, l'ensemble des N circuits série étant connectés en parallèle, la borne d'entrée positive dudit amplificateur opérationnel étant connectée à une tension de décalage, égale à la moitié de la tension d'alimentation, la sortie dudit amplificateur opérationnel délivrant, pour une programmation de chacun des interrupteurs programmables en position fermée ou ouverte, en fonction de la valeur des bits de ladite valeur numérique à convertir, ladite première tension analogique corrigée programmée $V_A$.

**4.** Convertisseur numérique/analogique selon l'une des revendications 1 à 3, **caractérisé en ce que** lesdits deuxièmes moyens correcteurs comprennent un amplificateur opérationnel dont la borne négative, montée en borne de pseudo-masse virtuelle, reçoit ladite première tension analogique corrigée programmée $V_A$, par l'intermédiaire d'une résistance de valeur déterminée, la sortie dudit amplificateur opérationnel étant connectée en contre-réaction par une résistance de même valeur à ladite borne négative, la borne positive dudit amplificateur opérationnel étant connectée à une tension de décalage égale à la moitié de la tension d'alimentation, la sortie dudit amplificateur opérationnel délivrant ladite deuxième tension analogique corrigée programmée $V_B$ sensiblement égale en grandeur et en signe à ladite somme pondérée desdites valeurs actives de ladite suite de tensions électriques.

**5.** Convertisseur numérique/analogique selon l'une des revendications 1 à 4, **caractérisé en ce que** lesdits troisièmes moyens correcteurs comprennent un amplificateur opérationnel correcteur de gain, dont la borne négative est connectée à ladite tension de référence, tension de masse, par l'intermédiaire d'une pluralité de N circuits série formés chacun par une résistance de même valeur et un interrupteur programmable, l'ensemble des N circuits série étant connectés en parallèle, la borne de sortie dudit amplificateur opérationnel étant connectée en contre-réaction à ladite borne négative par une résistance de même valeur, la borne positive dudit amplificateur opérationnel étant connectée à la sortie desdits deuxièmes moyens correcteurs et recevant ladite deuxième tension analogique corrigée programmée $V_B$, la sortie dudit amplificateur opérationnel délivrant, par application d'un gain inverse du terme de pondération à ladite deuxième tension analogique corrigée programmée, ladite tension analogique $V_{OUT}$ de valeur égale à la somme desdites valeurs actives de tensions électriques de ladite suite de tensions électriques.

**6.** Convertisseur numérique/analogique selon l'une des revendications précédentes, **caractérisé en ce que** pour une valeur numérique à convertir codée sur N bits, ledit courant image $I_i$ comporte une valeur de décalage proportionnelle à la moitié de la valeur du poids du bit le moins significatif, cette valeur étant introduite comme pseudo-valeur active permanente, chaque pluralité de circuit série des moyens générateurs programmables et des premiers moyens correcteurs comportant en outre une résistance permanente de même valeur connectée directement en parallèle sur l'ensemble des circuits série, le terme de pondération étant inversement proportionnel au nombre de bits à la valeur 1 de ladite valeur numérique à convertir augmenté de 1 et le terme de gain étant proportionnel au nombre de bits à la valeur 1 augmenté de 1, de ladite valeur numérique à convertir.

## Patentansprüche

**1.** Digital/Analogwandler mit Echtzeitverarbeitung, der einen Zahlenwert erhält, der auf N Bits kodiert ist, und der in eine Analogspannung mit einem Wert zwischen einer elektrischen Versorgungsspannung VCC und einer Referenzspannung, Massespannung, umzusetzen ist, umfassend:

- programmierbare Mittel zur Generierung eines elektrischen Bildstroms proportional zur Summe der aktiven

elektrischen Spannungswerte einer Reihe von N elektrischen Spannungen, die eine geometrische Folge mit Quotient ½ bilden und ein analoges Bild bilden von der Bedeutung der Bits zwischen dem signifikantesten Bit und dem am wenigsten signifikanten Bit, auf denen dieser umzusetzende Zahlenwert kodiert ist, diese aktiven Werte diesen elektrischen Spannungswerten dieser Reihe von Werten entsprechen, für die das analoge Bild der Bedeutung der Bits dieses umzusetzenden Zahlenwerts einem Bit mit dem Wert 1 entspricht; **dadurch gekennzeichnet, dass** er zumindest folgendes umfasst:

- erste programmierbare Korrekturmittel, die diesen elektrischen Bildstrom erhalten und die Erzeugung einer ersten korrigierten Analogspannung ermöglichen, proportional programmiert zum Unterschied zwischen dieser Versorgungsspannung VCC und der gewichteten Summe dieser aktiven elektrischen Spannungswerte der Reihe von elektrischen Spannungen, wobei der Gewichtungsterm dieser gewichteten Summe umgekehrt proportional zur Anzahl der Bits mit dem Wert 1 dieses umzusetzenden Zahlenwerts ist;

- zweite programmierbare Korrekturmittel, die diese erste programmierte korrigierte Analogspannung erhalten und die Erzeugung einer zweiten programmierten korrigierten Analogspannung ermöglichen, die in Größe und Vorzeichen merklich gleich programmiert ist wie diese gewichtete Summe dieser aktiven elektrischen Spannungswerte dieser Reihe von elektrischen Spannungen;

- dritte programmierbare Korrekturmittel, die diese zweite programmierte korrigierte Analogspannung erhalten und die Anwendung einer programmierten Verstärkung ermöglichen, die gleich dem Kehrwert des Gewichtungsterms ist, was es ermöglicht, diese Analogspannung zu erzeugen mit einem Wert zwischen dieser Versorgungsspannung und dieser Referenzspannung, einem Wert, der gleich ist wie die Summe dieser aktiven elektrischen Spannungswerte dieser Reihe von elektrischen Spannungen.

2. Digital/Analogwandler nach Anspruch 1, **dadurch gekennzeichnet, dass** diese programmierbaren Mittel zur Generierung eines Bildstroms proportional zur Summe der aktiven elektrischen Spannungswerte zumindest folgendes umfassen:

- eine Mehrzahl von N elektrischen Spannungsteilern $R_0/2R_0$, die zwischen dieser Versorgungsspannung und dieser Referenzspannung in Reihe verbunden sind, wobei R einen bestimmten Widerstandswert bezeichnet, der Eingangsanschluss des ersten Spannungsteilers mit der Versorgungsspannung VCC verbunden ist und der Eingangsanschluss von jedem nachfolgenden Spannungsteiler mit dem Mittelpunkt des Spannungsteilers benachbarten Ranges verbunden ist, wobei der Mittelpunkt von jedem Spannungsteiler des Ranges j eine elektrische Spannung mit dem Wert $Vcc/2^{N-j}$ liefert, die die Reihe der elektrischen Spannungswerte begründet;

- eine Mehrzahl von N in Reihe angeordneten Kreisen, von denen jeder durch einen Widerstand eines bestimmten Werts und einen programmierbaren Schalter ($b_0$, $b_j$ bis $b_3$) gebildet wird, der Eingangsanschluss von jedem Reihenkreis mit dem Mittelpunkt eines Spannungsteilers verbunden ist und eine elektrische Spannung mit dem Wert $Vcc/2^{N-j}$ erhält, jeder Reihenkreis, je nachdem, ob die geöffnete oder geschlossene Position dieses Schalters programmiert ist, durch ein Bit mit dem Wert 1 oder 0 dieses umzusetzenden Zahlenwerts, einen elementaren elektrischen Bildstrom $I_{ij}$ liefert, der proportional zu diesem Wert $Vcc/2^{N-j}$ ist, der einem aktiven Wert der elektrischen Spannungen dieser Reihe von elektrischen Spannungen für ein Bit mit Wert 1 entspricht, und ein elementarer elektrischer Bildstrom mit Wert Null, der einem nicht aktiven Wert der elektrischen Spannungen der Reihe der elektrischen Spannungen für ein Bit mit dem Wert 0 entspricht, der Ausgangsanschluss dieser Mehrzahl von Reihenkreisen parallel verbunden ist, um diesen elektrischen Bildstrom $I_i$, Summe der elementaren Bildströme $I_{ij}$, proportional zur Summe dieser aktiven elektrischen Spannungswerte, zu liefern.

3. Digital/Analogwandler nach einem der Ansprüche 1 oder 2, **dadurch gekennzeichnet, dass** diese ersten programmierbaren Korrekturmittel einen Operationsverstärker umfassen, dessen negativer Eingangsanschluss am Eingang als virtuelle Pseudomasse befestigt ist, diesen elektrischen Bildstrom $I_i$, der durch diese programmierbaren Generierungsmittel geliefert wird, erhält, der Ausgangsanschluss dieses Operationsverstärkers in Rückkopplung mit diesem negativen Anschluss verbunden ist durch Zwischenschaltung einer Mehrzahl von N Reihenkreisen, von denen jeder durch einen Widerstand des gleichen Wertes und einen programmierbaren Schalter gebildet ist, die Gesamtheit der N Reihenkreise parallel verbunden sind, der positive Eingangsanschluss dieses Operationsverstärkers mit einer Offsetspannung verbunden ist, die der Hälfte der Versorgungsspannung entspricht, der Ausgang dieses Operationsverstärkers für eine Programmierung von jedem der in offener oder geschlossener Position programmierbaren Schalter, in Abhängigkeit des Wertes der Bits dieses umzusetzenden Zahlenwertes, diese programmierte korrigierte Analogspannung $V_A$ liefert.

4. Digital/Analogwandler nach einem der Ansprüche 1 bis 3, **dadurch gekennzeichnet, dass** diese zweiten Korrekturmittel einen Operationsverstärker umfassen, dessen negativer Anschluss, der am Anschluss als virtuelle Pseudomasse befestigt ist, diese erste programmierte korrigierte Analogspannung $V_A$ durch Zwischenschaltung eines Widerstands mit einem bestimmten Wert erhält, der Ausgang dieses Operationsverstärkers in Rückkopplung durch einen Widerstand des gleichen Wertes mit diesem negativen Anschluss verbunden ist, der positive Anschluss dieses Operationsverstärkers an eine Offsetspannung angeschlossen ist, die der Hälfte der Versorgungsspannung entspricht, der Ausgang dieses Operationsverstärkers diese zweite programmierte korrigierte Analogspannung $V_B$ liefert, die in Größe und Vorzeichen merklich gleich ist, wie die gewichtete Summe dieser aktiven Werte dieser Reihe von elektrischen Spannungen.

5. Digital/Analogwandler nach einem der Ansprüche 1 bis 4, **dadurch gekennzeichnet, dass** diese dritten Korrekturmittel einen Operationsverstärker zur Verstärkungskorrektur umfassen, dessen negativer Anschluss mit dieser Referenzspannung verbunden ist, Massespannung, durch Zwischenschaltung von einer Mehrzahl von N Reihenkreisen, von denen jeder durch einen Widerstand mit dem gleichen Wert und einen programmierbaren Schalter gebildet ist, die Gesamtheit der N Reihenkreise parallel verbunden sind, der Ausgangsanschluss dieses Operationsverstärkers in Rückkopplung mit diesem negativen Anschluss durch einen Widerstand des gleichen Werts verbunden ist, der positive Anschluss dieses Operationsverstärkers mit dem Ausgang dieser zweiten Korrekturmittel verbunden ist und diese zweite programmierte korrigierte Analogspannung $V_B$ erhält, der Ausgang dieses Operationsverstärkers durch Anwendung einer Verstärkung mit dem Kehrwert des Gewichtungswerts zu dieser zweiten programmierten korrigierten Analogspannung, diese Analogspannung $V_{OUT}$ mit gleichem Wert wie die Summe dieser aktiven Werte der elektrischen Spannungen dieser Reihe von elektrischen Spannungen, liefert.

6. Digital/Analogwandler nach einem der vorherigen Ansprüche, **dadurch gekennzeichnet, dass** für einen umzusetzenden Zahlenwert, der auf N Bits kodiert ist, dieser Bildstrom $I_i$ einen Offsetwert umfasst, der proportional zur Hälfte des Wertes der Bedeutung des am wenigsten signifikanten Bits ist, wobei dieser Wert eingeführt wird als permanenter aktiver Pseudowert, wobei jede Mehrzahl von Reihenkreis der programmierbaren Generierungsmittel und der ersten Korrekturmittel, die des Weiteren einen permanenten Widerstand des gleichen Wertes umfasst, der direkt mit der Gesamtheit der Reihenkreise parallel verbunden ist, der Gewichtungsterm umgekehrt proportional zur Anzahl der Bits mit dem Wert 1 dieses um 1 erhöhten umzusetzenden Zahlenwerts ist und der Verstärkungsterm proportional zur Anzahl der um 1 erhöhten Anzahl der Bits mit dem Wert 1 ist, dieses umzusetzenden Zahlenwerts.

## Claims

1. Instantaneously acting digital-to-analogue converter receiving a digital value, coded on N bits, to be converted into an analogue voltage having a value ranging between an electric supply voltage Vcc and a reference voltage, ground voltage, comprising:

- programmable means for generating an image electric current proportional to the sum of the active values of electric voltages in a series of N electric voltages constituting a 1/2 geometric progression and forming an analogue image of the weight of the bits between the most significant bit and the least significant bit on which said digital value to be converted is coded, said active values corresponding to said electric voltages in this series of values for which the analogue image of the weight of bits of said digital value to be converted corresponds to a bit of value 1;

**characterised in that** it comprises at least:

- first programmable corrector means receiving said image electric current and enabling a first programmed, corrected analogue voltage to be generated, proportional to the difference between said supply voltage Vcc and the weighted sum of said active values of electric voltages in the series of electric voltages, the weighting term of said weighted sum being inversely proportional to the number of bits of value 1 of said digital value to be converted;
- second corrector means receiving said first programmed, corrected analogue voltage and enabling a second programmed, corrected analogue voltage to be generated, substantially equal in value and sign to said weighted sum of said active values of electric voltages in said series of electric voltages;
- third corrector means receiving said second programmed, corrected analogue voltage and enabling a programmed gain to be applied, equal to the inverse of said weighting term, which enables said analogue voltage

with a value ranging between said supply voltage and said reference voltage to be generated, said value being equal to the sum of said active values of electric voltages in said series of electric voltages.

**2.** Digital-to-analogue converter as claimed in claim 1, **characterised in that** said programmable means for generating an image current proportional to the sum of the active values of electric voltages comprise at least:

- a plurality of N electric voltage divider bridges $R_0/2R_0$ connected in a cascade arrangement between said supply voltage and said reference voltage, $R_0$ denoting a given resistance value, the input terminal of the first divider bridge being connected to the supply voltage Vcc and the input terminal of each successive divider bridge being connected to the mid-point of the divider bridge of adjacent rank, the mid-point of each divider bridge of rank j outputting an electric voltage of value $Vcc/2^{N-j}$ constituting the series of electric voltage values;
- a plurality of N series circuits, each formed by a resistor of a given value and a programmable switch ($b_0$, $b_j$ to $b_3$), the input terminal of each series circuit being connected to the mid-point of a divider bridge and receiving an electric voltage of value $Vcc/2^{N-j}$, each series circuit, depending on whether this switch is programmed to a closed or open position by a bit of value 1 or 0 of said digital value to be converted, outputting an elementary image electric current $I_{ij}$ proportional to said value $Vcc/2^{N-j}$, corresponding to an active value of the electric voltages of said series of electric voltages for a bit of value 1 and an elementary image electric current of zero value, corresponding to a non-active value of the electric voltages in the series of electric voltages for a bit of value 0, the output terminal of said plurality of series circuits being connected in parallel in order to output said image electric current $I_i$, being the sum of the elementary image currents $I_{ij}$, proportional to the sum of said active values of electric voltages.

**3.** Digital-to-analogue converter as claimed in one of claims 1 or 2, **characterised in that** said first programmable corrector means incorporate an operational amplifier, the negative input terminal of which, mounted as a virtual pseudo-ground terminal, receives said image electric current $I_i$ output by said programmable generator means, the output terminal of said operational amplifier being connected in counter-reaction to said negative terminal via a plurality of N series circuits, each made up of a resistor of a same value and a programmable switch, the group of N serial circuits being connected in parallel, the positive input terminal of said operational amplifier being connected to a shift voltage, equal to half the supply voltage, the output of said operational amplifier outputting, when each of the programmable switches is programmed to a closed or open position depending on the value of the bits of said digital value to be converted, said first programmed, corrected analogue voltage $V_A$.

**4.** Digital-to-analogue converter as claimed in one of claims 1 to 3, **characterised in that** said second corrector means incorporate an operational amplifier, the negative terminal of which, mounted as a virtual pseudo-ground terminal, receives said first programmed, corrected analogue voltage $V_A$ via a resistor of a given value, the output of said operational amplifier being connected in counter-reaction via a resistor of a same value to said negative terminal, the positive terminal of said operational amplifier being connected to a shift voltage equal to half the supply voltage, the output of said operational amplifier outputting said second programmed, corrected analogue voltage $V_B$ substantially equal in value and sign to said weighted sum of said active values of said series of electric voltages.

**5.** Digital-to-analogue converter as claimed in one of claims 1 to 4, **characterised in that** said third corrector means incorporate a gain-correcting operational amplifier, the negative terminal of which is connected to said reference voltage, ground voltage, via a plurality of N series circuits each formed by a resistor of a same value and a programmable switch, the group of N series circuits being connected in parallel, the output terminal of said operational amplifier being connected in counter-reaction to said negative terminal by a resistor of a same value, the positive terminal of said operational amplifier being connected to the output of said second corrector means and receiving said second programmed, corrected analogue voltage $V_B$, the output of said operational amplifier applying an inverse gain of the weighting term to said second programmed, corrected analogue voltage in order to output said analogue voltage $V_{OUT}$ having a value equal to the sum of said active values of electric voltages in said series of electric voltages.

**6.** Digital-to-analogue converter as claimed in one of the preceding claims, **characterised in that**, for a digital value to be converted, coded on N bits, said image current $I_i$ contains a shift value proportional to half the value of the weight of the least significant bit, this value being introduced as a permanent active pseudo-value, each plurality of series circuits of the programmable generator means and first corrector means additionally having a permanent resistor of a same value connected directly in parallel on the group of series circuits, the weighting term being inversely proportional to the number of bits of value 1 of said digital value to be converted incremented by 1 and

the gain term being proportional to the number of bits of value 1 incremented by 1 of said digital value to be converted.

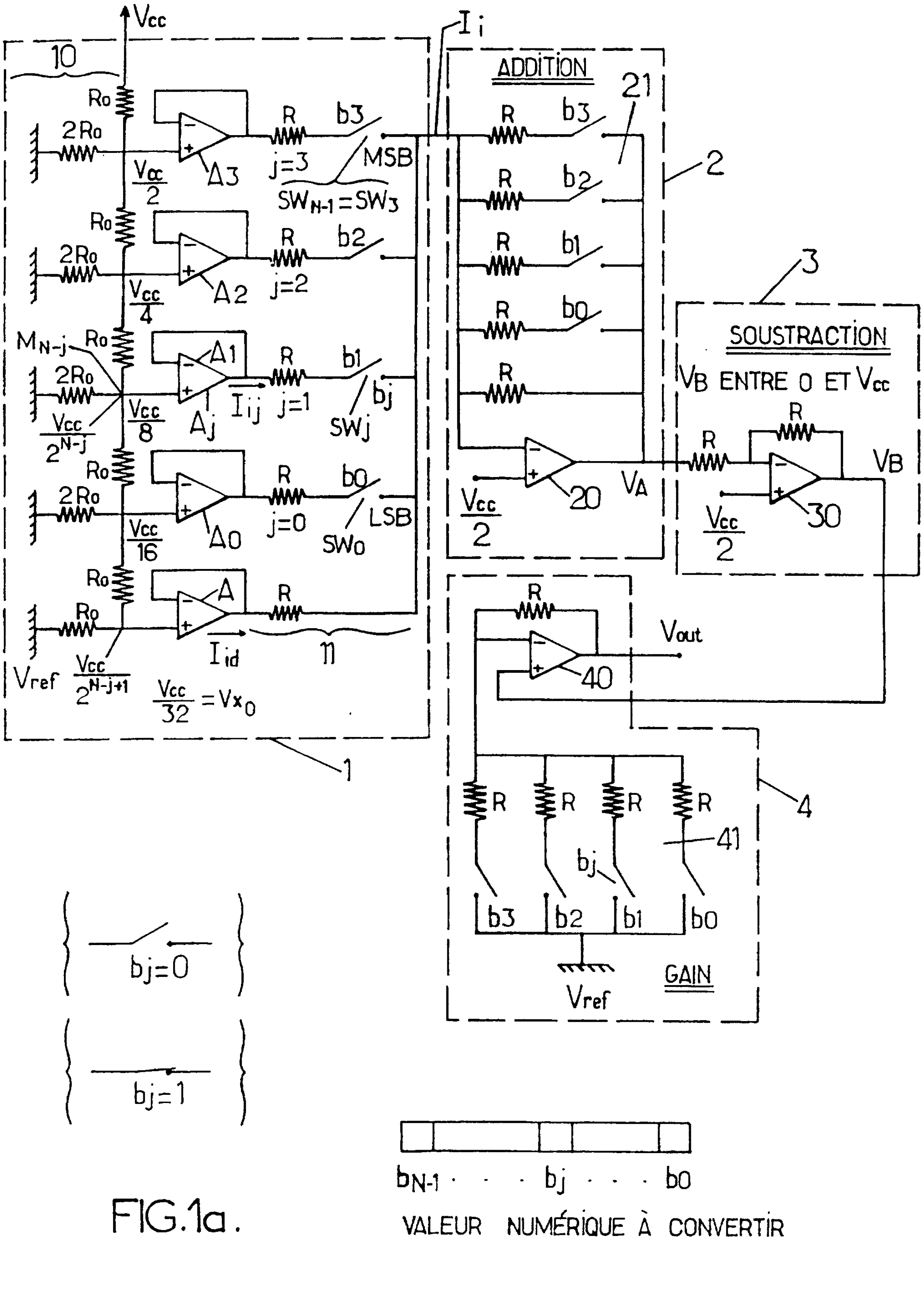
Vcc
10
Ro
2Ro
Vcc/2
Δ3
R
b3
j=3
MSB
SWN-1 = SW3
A2
b2
j=2
Vcc/4
MN-j
A1
b1
j=1
bj
Iij
Aj
SWj
Vcc/8
Vcc/2N-j
A0
b0
j=0
LSB
SW0
Vcc/16
A
Iid
11
Vref
Vcc/2N-j+1
Vcc/32 = Vx0
1
Ii
ADDITION
21
2
20
VA
Vcc/2
3
SOUSTRACTION
VB ENTRE 0 ET Vcc
VB
30
Vout
40
41
4
GAIN
bj=0
bj=1
bN-1 . . . bj . . . b0
VALEUR NUMÉRIQUE À CONVERTIR

FIG.1a.

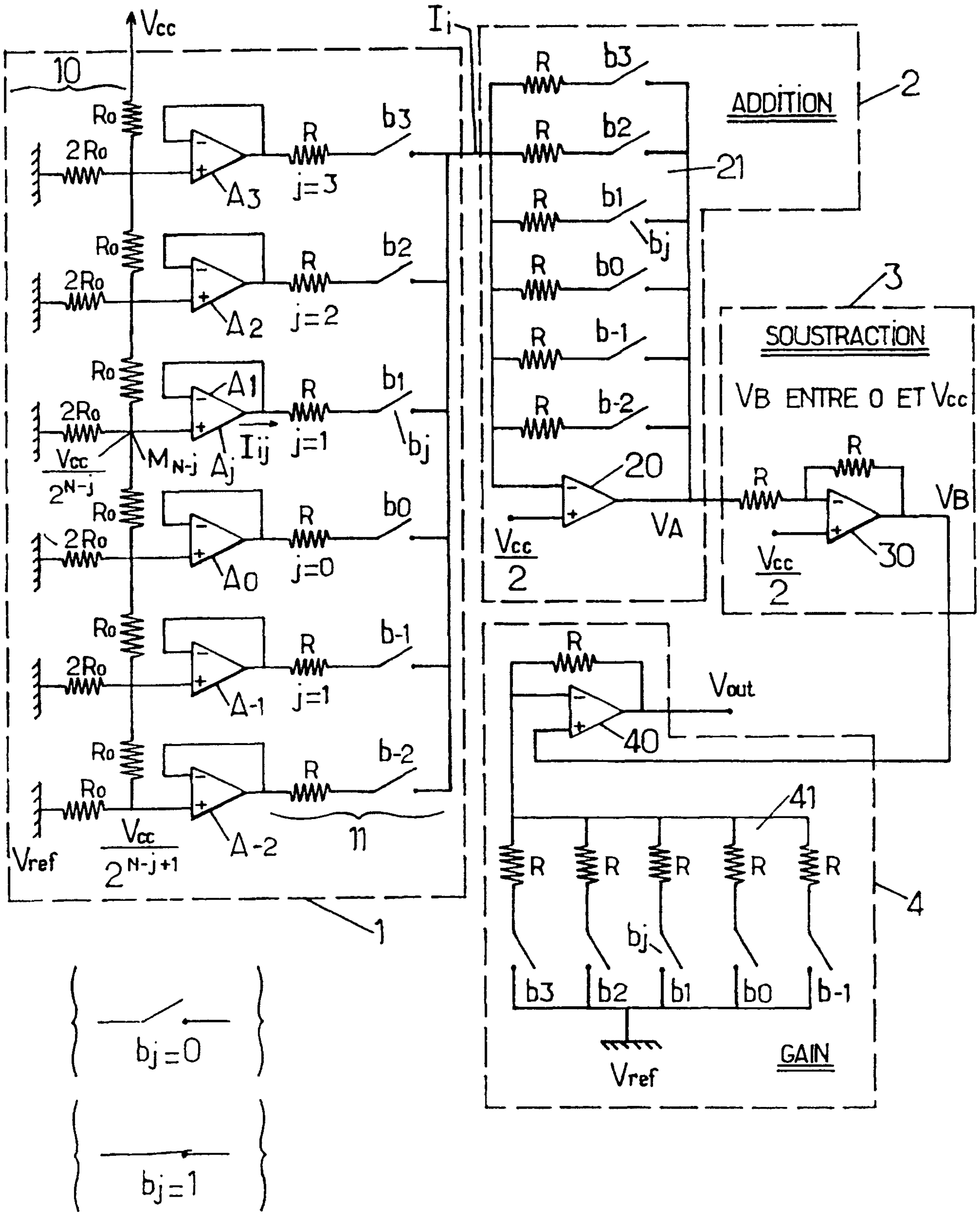
Vcc
10
Ro
2 Ro
A3
R
j=3
b3
A2
j=2
b2
A1
j=1
b1
bj
Vcc / 2^N-j
MN-j
Aj
Iij
A0
j=0
b0
A-1
b-1
A-2
b-2
Vref
Vcc / 2^N-j+1
11
1
Ii
ADDITION
2
21
20
VA
Vcc / 2
SOUSTRACTION
3
VB ENTRE 0 ET Vcc
VB
30
Vout
40
41
4
GAIN
bj=0
bj=1

FIG.1b.